(19) Europäisches Patentamt
European Patent Office
Office européen des brevets

(11) **EP 3 920 218 B1**

(12) **EUROPEAN PATENT SPECIFICATION**

(45) Date of publication and mention
of the grant of the patent:
**20.12.2023 Bulletin 2023/51**

(21) Application number: **19920973.5**

(22) Date of filing: **22.03.2019**

(51) International Patent Classification (IPC):
*H04L 25/03* (2006.01)     *H04L 25/02* (2006.01)
*H01L 25/065* (2023.01)

(52) Cooperative Patent Classification (CPC):
**H04L 25/0272; H01L 23/64; H04L 25/0278;**
**H04L 25/03127; H04L 25/03885; H01L 24/13;**
H01L 24/16; H01L 2224/16227; H01L 2924/15192;
H01L 2924/19042; H01L 2924/19043;
H01L 2924/19103; H01L 2924/19104;
H01L 2924/19105; H01L 2924/30111

(86) International application number:
**PCT/CN2019/079223**

(87) International publication number:
**WO 2020/191519 (01.10.2020 Gazette 2020/40)**

(54) **EQUALISATION CIRCUIT, PACKAGING APPARATUS, AND DATA TRANSMISSION APPARATUS**

AUSGLEICHSSCHALTUNG, VERPACKUNGSVORRICHTUNG UND
DATENÜBERTRAGUNGSVORRICHTUNG

CIRCUIT D'ÉGALISATION, APPAREIL DE MISE SOUS BOÎTIER ET APPAREIL DE TRANSMISSION
DE DONNÉES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.12.2021 Bulletin 2021/49**

(73) Proprietor: **Huawei Technologies Co., Ltd.
Shenzhen, Guangdong 518129 (CN)**

(72) Inventors:
• **LUO, Duona**
  **Shenzhen, Guangdong 518129 (CN)**
• **FAN, Wenkai**
  **Shenzhen, Guangdong 518129 (CN)**
• **CAI, Shujie**
  **Shenzhen, Guangdong 518129 (CN)**

(74) Representative: **Thun, Clemens
Mitscherlich PartmbB
Patent- und Rechtsanwälte
Karlstraße 7
80333 München (DE)**

(56) References cited:
**US-A1- 2004 071 219     US-A1- 2008 238 587
US-A1- 2012 139 669     US-A1- 2014 314 136**

**Description**

**TECHNICAL FIELD**

This application relates to the field of circuit packaging, and in particular, to an equalization circuit, an package apparatus, and a data transmission apparatus.

**BACKGROUND**

SERDES, short for serializer/deserializer, is a mainstream time division multiplexing (TDM) and point-to-point (P2P) serial communication technology. According to the technology, a plurality of low-speed parallel signals are converted into high-speed serial signals at a transmitter side, then transmitted through a transmission medium (an optical cable or a copper wire), and finally converted back into low-speed parallel signals at a receiver side. This point-to-point serial communication technology fully uses a channel capacity of the transmission medium, thereby reducing the numbers of required transmission channels and device pins, and greatly reducing communication costs.

Further, US 2012/139669 A1 refers to a passive equalizer circuit incorporated at a front-end of an integrated receiver circuit using passive components that are distributed between inside and outside of an integrated circuit package. Further, US 2004/071219 A1 refers to a high speed data link including transmitter equalization and (passive) receiver equalization to compensate for frequency distortion of the data link. Further, US2014314136 A1 discloses a passive equalizer for a differential transmission system. The passive equalizer circuit having two inductances in series with a resistor in-between the inductances. However, the resistor is present in addition to the impedance network of the receiver which is not integrated into the equalizer circuit.

When a plurality of chips work cooperatively, signal receiving and sending need to be implemented between the chips over a SerDes link. As a communication rate greatly increases, loss caused by a SerDes passive link significantly deteriorates signal quality at a receiver side (a receiver chip). Therefore, an equalization technology is widely applied to high-speed SerDes communication to compensate for the channel loss. An active equalizer is designed inside a chip, and includes a feedforward equalizer, a decision feedback equalizer, a continuous time linear equalizer, and the like. Because the active equalizer is disposed inside the chip, additional power and an additional chip area need to be consumed. In addition, a passive equalizer may be constructed outside the chip, for example, on a printed circuit board (PCB) or inside a package, by a device such as a resistor, an inductor, or a capacitor. However, a passive equalizer in the conventional technology mainly faces the following two problems: First, the passive equalizer in the conventional technology uses a surface-mount device structure and is not packaged together with the chip, resulting in a relatively low working frequency that cannot meet a high-speed SerDes interconnection requirement. Second, signal fan-out space on the package or the PCB needs to be occupied to use the passive equalizer, and a fan-out density is reduced.

Therefore, the foregoing problems in the conventional technology need to be mitigated.

**SUMMARY**

This above mentioned problem is solved by the subject matter of the independent claims. Further implementation forms are provided in the dependent claims. An embodiment of this application provides an equalization circuit. A receiver impedance network and a passive equalizer are connected by a first connector and a second connector, so that the receiver impedance network and the passive equalizer work cooperatively, and a resistance value of the receiver impedance network is adjusted to implement a mechanism with an adjustable receiver bandwidth gain. In addition, the passive equalizer does not use a conventional surface-mount device structure, but is packaged together with a receiver chip, thereby increasing a working frequency and meeting a high-speed SerDes interconnection requirement. In addition, as the passive equalizer is connected to the first connector and the second connector, compared with a conventional equalization circuit design, the passive equalizer in the equalization circuit is disposed outside the receiver chip and is connected to the first connector and the second connector, and therefore does not occupy additional package fan-out space or an additional chip area.

In view of this, a first aspect of this application provides an equalization circuit, including a receiver impedance network disposed inside a receiver chip, and a passive equalizer disposed outside the receiver chip. The passive equalizer may have two ports. The receiver impedance network is connected to the passive equalizer by a first connector and a second connector, and is connected to a first trace and a second trace of a differential trace by the first connector and the second connector respectively. The differential trace is configured to connect the receiver chip and a transmitter chip. The receiver chip may be a wafer die.

It can be learned from the first aspect that, the receiver impedance network and the passive equalizer are connected by the first connector and the second connector, so that the receiver impedance network and the passive equalizer work cooperatively, and a resistance value of the receiver impedance network is adjusted to implement a mechanism with an adjustable receiver bandwidth gain, thereby increasing a working frequency and meeting a high-speed SerDes interconnection requirement. In addition, as the passive equalizer is connected to the first connector and the second connector, compared with a conventional equalization circuit design, the passive equalizer in the equalization circuit is disposed outside the receiver chip and is connected to the first connector and the second connector, and therefore does not occupy additional package fan-out space or an additional chip area.

With reference to the first aspect, in a first possible implementation, the first connector includes a first bump, one end of the first bump is connected to a first end of the passive equalizer, and the other end of the first bump is connected to the receiver chip; and the second connector includes a second bump, one end of the second bump is connected to a second end of the passive equalizer, and the other end of the second bump is connected to the receiver chip. The first bump and the second bump may be cylindrical or spherical.

It can be learned from the first possible implementation of the first aspect that, the passive equalizer and the receiver chip are connected by the first bump and the second bump, thereby implementing connection of the equalization circuit.

With reference to the first possible implementation of the first aspect, in a second possible implementation, the first connector further includes a first pin and a first wire, the first pin and the first wire may be connected through bonding, a first end of the first pin is connected to the first bump, a second end of the first pin is connected to the receiver chip, and the second end of the first pin is connected to a first end of the receiver impedance network by the first wire. The second connector further includes a second pin and a second wire, the second pin and the second wire may be connected through bonding, a first end of the second pin is connected to the second bump, a second end of the second pin is connected to the receiver chip, and the second end of the second pin is connected to a second end of the receiver impedance network by the second wire.

It can be learned from the second possible implementation of the first aspect that, the first bump and the second bump implement the connection between the receiver impedance network and the passive equalizer by the first pin and the first wire, and the second pin and the second wire, respectively, and a resistance value of the receiver impedance network is adjusted to implement a mechanism with an adjustable receiver bandwidth gain, thereby increasing a working frequency and meeting a high-speed SerDes interconnection requirement.

With reference to any one of the first aspect and the first or the second possible implementation of the first aspect, in a third possible implementation, the passive equalizer is connected in parallel to the receiver impedance network, and the passive equalizer includes at least one resistor and at least one inductor that are connected in series.

It can be learned from the third possible implementation of the first aspect that, the passive equalizer is connected to the receiver impedance network in parallel, and the passive equalizer includes at least one resistor and at least one inductor that are connected in series, to implement a passive equalization function of the passive equalizer.

With reference to the third possible implementation of the first aspect, in a fourth possible implementation, the passive equalizer includes a first inductor, a second inductor, and a first resistor. A first end of the first inductor is connected to the first connector, a second end of the first inductor is connected to a first end of the first resistor, a second end of the first resistor is connected to a first end of the second inductor, and a second end of the second inductor is connected to the second connector. The first end of the first inductor is further connected to the first trace, and the second end of the second inductor is further connected to the second trace.

It can be learned from the fourth possible implementation of the first aspect that, the passive equalizer implements an inductor-resistor-inductor L-R-L passive equalization structure by the first inductor, the second inductor, and the first resistor, to implement a passive equalization function.

With reference to the third possible implementation of the first aspect, in a fifth possible implementation, the passive equalizer includes a second resistor, a third resistor, and a third inductor. A first end of the second resistor is connected to the first connector, a second end of the second resistor is connected to a first end of the third inductor, a second end of the third inductor is connected to a first end of the third resistor, and a second end of the third resistor is connected to the second connector. The first end of the second resistor is further connected to the first trace, and the second end of the third resistor is further connected to the second trace.

It can be learned from the fifth possible implementation of the first aspect that, the passive equalizer implements a resistor-inductor-resistor R-L-R passive equalization structure by the second resistor, the third resistor, and the third inductor, to implement a passive equalization function.

With reference to any one of the first aspect and the first or the second possible implementation of the first aspect, in a sixth possible implementation, the passive equalizer is connected in series to the receiver impedance network, and the passive equalizer includes at least one inductor.

It can be learned from the sixth possible implementation of the first aspect that, the passive equalizer is connected in series to the receiver impedance network, to implement the connection between the receiver impedance network and the passive equalizer. Because the passive equalizer is connected in series to the receiver impedance network, the receiver impedance network can function as a resistor. Therefore, the passive equalizer needs only at least one inductor to adjust a resistance value of the receiver impedance network to implement a mechanism with an adjustable receiver bandwidth gain, thereby increasing a working frequency and meeting a high-speed SerDes interconnection requirement.

With reference to the sixth possible implementation of the first aspect, in a seventh possible implementation, the equalization circuit further includes a third connector and a fourth connector, structures of the third connector and the fourth connector are the same as those of the first connector and the second connector, and the passive equalizer includes a fourth inductor and a fifth inductor. A first end of the fourth inductor is connected to the first connector, a second end of the fourth inductor is connected to the first end of the receiver impedance network by the third connector, the second end of the receiver impedance network is connected to a first end of the fifth inductor by the fourth connector, and a second end of the fifth inductor is connected to the second connector. The first end of the fourth inductor is further connected to the first trace, and the second end of the fifth inductor is further connected to the second trace. The foregoing connection manner may be implemented through bonding, or may be implemented through etching on an integrated circuit board.

It can be learned from the seventh possible implementation of the first aspect that, the passive equalizer and the receiver impedance network are connected in series by the third connector and the fourth connector. Because of a resistor function of the receiver impedance network, a resistor can be saved in the passive equalizer, and a passive equalization function can be implemented by disposing only the fourth inductor and the fifth inductor in cooperation with the resistor function of the receiver impedance network.

With reference to any one of the third to the seventh possible implementations of the first aspect, in an eighth possible implementation, the inductor is a spiral inductor. The spiral inductor may be a circular spiral inductor, or may be a square spiral inductor. The resistor is a package-embedded high-density metal resistor. The package-embedded high-density metal resistor may be a resistor formed by integrating a plurality of high-density metal resistors, or may be an independent resistor.

It can be learned from the eighth possible implementation of the first aspect that, in such a centralized disposing manner in which the inductor is a spiral inductor, an area of the passive equalizer is greatly reduced, and original signal fan-out space is almost unaffected. The package-embedded high-density metal resistor is implemented by a trace parasitic resistor. Through high-density winding, an extremely large trace length is achieved in a relatively small region, thereby obtaining considerable trace resistance.

With reference to any one of the first aspect or the second to the eighth possible implementations of the first aspect, in a ninth possible implementation, the receiver impedance network is a switched resistor network or a voltage-controlled resistor.

It can be learned from the ninth possible implementation of the first aspect that, a manner of a switched resistor network or a voltage-controlled resistor makes the receiver impedance network become a impedance network with an adjustable resistance value, to cooperate with the passive equalizer to form an adjustable equalizer.

An embodiment of this application further provides an package apparatus. A receiver impedance network in a receiver chip and a passive equalizer in a substrate are connected by a first connector and a second connector, so that the receiver impedance network and the passive equalizer work cooperatively, and a resistance value of the receiver impedance network is adjusted to implement a mechanism with an adjustable receiver bandwidth gain. In addition, the passive equalizer does not use a conventional surface-mount device structure, but is packaged together with the receiver chip, thereby increasing a working frequency and meeting a high-speed SerDes interconnection requirement. In addition, as the passive equalizer is connected to the first connector and the second connector, compared with a conventional equalization circuit design, the passive equalizer in the equalization circuit is disposed outside the receiver chip and is connected to the first connector and the second connector, and therefore does not occupy additional package fan-out space or an additional chip area.

In view of this, a second aspect of this application provides an package apparatus. The package apparatus includes a receiver chip and a substrate. The substrate may be a substrate that includes a metal trace and that is made of an organic material/silicon material/glass material. The receiver chip is disposed on a side of the substrate and is connected to the substrate. A passive equalizer is disposed in the substrate. A receiver impedance network is disposed in the receiver chip. The receiver impedance network is connected to the passive equalizer by a first connector and a second connector, and is connected to a first trace and a second trace of a differential trace by the first connector and the second connector respectively. The differential trace is configured to connect the receiver chip and a transmitter chip. The first trace and the second trace may be disposed on the substrate through etching.

It can be learned from the second aspect that, the receiver chip and the substrate are connected by the first connector and the second connector, to connect the receiver impedance network and the passive equalizer, so that the receiver impedance network and the passive equalizer work cooperatively, and a resistance value of the receiver impedance network is adjusted to implement a mechanism with an adjustable receiver bandwidth gain, thereby increasing a working frequency and meeting a high-speed SerDes interconnection requirement. In addition, as the passive equalizer is connected to the first connector and the second connector, compared with a conventional equalization circuit design, the passive equalizer in the equalization circuit is disposed outside the receiver chip and is connected to the first connector and the second connector, and therefore does not occupy additional package fan-out space or an additional chip area.

With reference to the second aspect, in a first possible implementation, the first connector includes a first bump, one end of the first bump is connected to a first end of the passive equalizer, and the other end of the first bump is connected to the receiver chip; and the second connector includes a second bump, one end of the second bump is connected to a second end of the passive equalizer, and the other end of the second bump is connected to the receiver chip. The first bump and the second bump may be cylindrical or spherical.

It can be learned from the first possible implementation of the second aspect that, the passive equalizer and the receiver chip are connected by the first bump and the second bump, thereby implementing a flip chip package of the package apparatus.

With reference to the first possible implementation of the second aspect, in a second possible implementation, the first connector further includes a first pin and a first wire, a first end of the first pin is connected to the first bump, a second end of the first pin is connected to the receiver chip, and the second end of the first pin is connected to a first end of the receiver impedance network by the first wire. The second connector further includes a second pin and a second wire, the second pin and the second wire may be connected through bonding, a first end of the second pin is connected to the second bump, a second end of the second pin is connected to the receiver chip, and the second end of the second pin is connected to a second end of the receiver impedance network by the second wire.

It can be learned from the second possible implementation of the second aspect that, the first bump and the second bump implement the connection between the receiver impedance network and the passive equalizer by the first pin and the first wire, and the second pin and the second wire respectively, and a resistance value of the receiver impedance network is adjusted to implement a mechanism with an adjustable receiver bandwidth gain, thereby increasing a working frequency and meeting a high-speed SerDes interconnection requirement.

With reference to any one of the second aspect and the first or the second possible implementation of the first aspect, in a third possible implementation, the passive equalizer is connected in parallel to the receiver impedance network, and the passive equalizer includes at least one resistor and at least one inductor that are connected in series.

It can be learned from the third possible implementation of the second aspect that, the passive equalizer is connected to the receiver impedance network in parallel, and the passive equalizer includes at least one resistor and at least one inductor that are connected in series, to implement a passive equalization function of the passive equalizer.

With reference to the third possible implementation of the second aspect, in a fourth possible implementation, the passive equalizer includes a first inductor, a second inductor, and a first resistor. A first end of the first inductor is connected to the first connector, a second end of the first inductor is connected to a first end of the first resistor, a second end of the first resistor is connected to a first end of the second inductor, and a second end of the second inductor is connected to the second connector. The first end of the first inductor is further connected to the first trace, and the second end of the second inductor is further connected to the second trace.

It can be learned from the fourth possible implementation of the second aspect that, the passive equalizer implements an inductor-resistor-inductor L-R-L passive equalization structure by the first inductor, the second inductor, and the first resistor, to implement a passive equalization function.

With reference to the fourth possible implementation of the second aspect, in a fifth possible implementation, the first inductor, the second inductor, and the first resistor are all disposed on a surface of the substrate that faces the receiver chip. The first inductor, the second inductor, and the first resistor may be disposed on the surface of the substrate through etching.

It can be learned from the fifth possible implementation of the second aspect that, the first inductor, the second inductor, and the first resistor are all disposed on the surface of the substrate that faces the receiver chip, so that when the substrate is connected to the receiver chip, the first inductor, the second inductor, and the first resistor can be directly connected to the receiver impedance network.

With reference to the third possible implementation of the second aspect, in a sixth possible implementation, the passive equalizer includes a second resistor, a third resistor, and a third inductor. A first end of the second resistor is connected to the first connector, a second end of the second resistor is connected to a first end of the third inductor, a second end of the third inductor is connected to a first end of the third resistor, and a second end of the third resistor is connected to the second connector. The first end of the second resistor is further connected to the first trace, and the second end of the third resistor is further connected to the second trace.

It can be learned from the sixth possible implementation of the second aspect that, the passive equalizer implements a resistor-inductor-resistor R-L-R passive equalization structure by the second resistor, the third resistor, and the third inductor, to implement a passive equalization function.

With reference to the sixth possible implementation of the second aspect, in a seventh possible implementation, the first resistor, the second resistor, and the third inductor are all disposed on a surface of the substrate that faces the receiver chip. The first resistor, the second resistor, and the third inductor may be disposed on the surface of the substrate through etching.

It can be learned from the seventh possible implementation of the second aspect that, the first resistor, the second resistor, and the third inductor are all disposed on the surface of the substrate that faces the receiver chip, so that when the substrate is connected to the receiver chip, the first resistor, the second resistor, and the third inductor can be directly connected to the receiver impedance network.

With reference to any one of the second aspect and the first or the second possible implementation of the first aspect, in an eighth possible implementation, the passive equalizer is connected in series to the receiver impedance network, and the passive equalizer includes at least one inductor.

It can be learned from the eighth possible implementation of the second aspect that, the passive equalizer is connected in series to the receiver impedance network, to implement the connection between the receiver impedance network and the passive equalizer. Because the passive equalizer is connected in series to the receiver impedance network, the receiver impedance network can function as a resistor. Therefore, the passive equalizer needs only at least one inductor to adjust a resistance value of the receiver impedance network to implement a mechanism with an adjustable receiver bandwidth gain, thereby increasing a working frequency and meeting a high-speed SerDes interconnection requirement.

With reference to the eighth possible implementation of the second aspect, in a ninth possible implementation, the equalization circuit further includes a third connector and a fourth connector, structures of the third connector and the fourth connector are the same as those of the first connector and the second connector, and the passive equalizer includes a fourth inductor and a fifth inductor. A first end of the fourth inductor is connected to the first connector, a second end of the fourth inductor is connected to the first end of the receiver impedance network by the third connector, the second end of the receiver impedance network is connected to a first end of the fifth inductor by the fourth connector, and a second end of the fifth inductor is connected to the second connector. The first end of the fourth inductor is further connected to the first trace, and the second end of the fifth inductor is further connected to the second trace. The foregoing connection manner may be implemented through bonding, or may be implemented through etching on the substrate.

It can be learned from the ninth possible implementation of the second aspect that, the passive equalizer and the receiver impedance network are connected in series by the third connector and the fourth connector. Because of a resistor function of the receiver impedance network, a resistor can be saved in the passive equalizer, and a passive equalization function can be implemented by disposing only the fourth inductor and the fifth inductor in cooperation with the resistor function of the receiver impedance network.

With reference to the ninth possible implementation of the second aspect, in a tenth possible implementation, the fourth inductor and the fifth inductor are both disposed on a surface of the substrate that faces the receiver chip. The fourth inductor and the fifth inductor may be disposed on the surface of the substrate through etching.

It can be learned from the tenth possible implementation of the second aspect that, the fourth inductor and the fifth inductor are both disposed on the surface of the substrate that faces the receiver chip, so that when the substrate is connected to the receiver chip, the fourth inductor and the fifth inductor can be directly connected to the receiver impedance network.

With reference to any one of the third to the tenth possible implementations of the second aspect, in an eleventh possible implementation, the inductor is a spiral inductor. The spiral inductor may be a circular spiral inductor, or may be a square spiral inductor. The resistor is a package-embedded high-density metal resistor. The package-embedded high-density metal resistor may be a resistor formed by integrating a plurality of high-density metal resistors, or may be an independent resistor.

It can be learned from the eleventh possible implementation of the second aspect that, in such a centralized disposing manner in which the inductor is a spiral inductor, an area of the passive equalizer is greatly reduced, and original signal fan-out space is almost unaffected. The package-embedded high-density metal resistor is implemented by a trace parasitic resistor. Through high-density winding, an extremely large trace length is achieved in a relatively small region, thereby obtaining considerable trace resistance.

With reference to any one of the second aspect or the second to the eleventh possible implementations of the second aspect, in a twelfth possible implementation, the receiver impedance network is a switched resistor network or a voltage-controlled resistor.

It can be learned from the twelfth possible implementation of the second aspect that, the manner of a switched resistor network or a voltage-controlled resistor makes the receiver impedance network become a impedance network with an adjustable resistance value, to cooperate with the passive equalizer to form an adjustable equalizer.

With reference to any one of the second aspect or the second to the twelfth possible implementations of the second aspect, in a thirteenth possible implementation, the package apparatus further includes a transmitter chip, the transmitter chip is disposed on a side of the substrate that faces the receiver chip, and the differential trace is disposed in the substrate. The differential trace may be disposed in the substrate through etching.

It can be learned from the thirteenth possible implementation of the second aspect that, the transmitter chip and the receiver chip are disposed on the same substrate, so that the transmitter chip and the receiver chip form a complete package apparatus, and signal exchange between the transmitter chip and the receiver chip is implemented through connection of the differential trace.

With reference to any one of the second aspect or the second to the thirteenth possible implementations of the second aspect, in a fourteenth possible implementation, the package apparatus is at least one of a silicon-based package, an organic resin material package, a fan-out package, or a glass package.

It can be learned from the fourteenth possible implementation of the second aspect that, the package apparatus is at least one of the silicon-based package, the organic resin material package, the fan-out package, or the glass package, and the substrate and the receiver chip are packaged to form a complete package apparatus.

An embodiment of this application provides a data transmission apparatus, including a printed circuit board and an package apparatus that is provided in this application and that is connected to the printed circuit board, so that the package apparatus can provide a higher working frequency on the printed circuit board, to meet a high-speed SerDes interconnection requirement. In addition, because a passive equalizer in the package apparatus does not occupy additional package fan-out space or an additional chip area, the package apparatus correspondingly occupies a smaller area on the printed circuit board.

In view of this, a third aspect of this application provides a data transmission apparatus. The data transmission apparatus includes a printed circuit board and an on-package apparatus connected to the printed circuit board. The package apparatus is the package apparatus provided in any one of the second aspect or the possible implementations of the second aspect.

It can be learned from the foregoing technical solutions that the embodiments of this application have the following advantages:

In the embodiments of this application, an equalization circuit, an package apparatus, and a data transmission apparatus are provided. The equalization circuit includes a receiver impedance network disposed inside a receiver chip, and a passive equalizer disposed outside the receiver chip. The receiver impedance network is connected to the passive equalizer by a first connector and a second connector, and is connected to a first trace and a second trace of a differential trace by the first connector and the second connector respectively. The differential trace is configured to connect the receiver chip and a transmitter chip. The receiver impedance network and the passive equalizer are connected by the first connector and the second connector, so that the receiver impedance network and the passive equalizer work cooperatively, and a resistance value of the receiver impedance network is adjusted to implement a mechanism with an adjustable receiver bandwidth gain, thereby increasing a working frequency and meeting a high-speed SerDes interconnection requirement. In addition, compared with a conventional equalization circuit design, the passive equalizer in the equalization circuit is disposed outside the receiver chip and is connected to the first connector and the second connector, and therefore does not occupy additional package fan-out space or an additional chip area. The package apparatus includes a receiver chip and a substrate. The receiver chip is disposed on a side of the substrate and is connected to the substrate. A passive equalizer is disposed in the substrate. A receiver impedance network is disposed in the receiver chip. The receiver impedance network is connected to the passive equalizer by a first connector and a second connector, and is connected to a first trace and a second trace of a differential trace by the first connector and the second connector respectively. The differential trace is configured to connect the receiver chip and a transmitter chip. The receiver impedance network in the receiver chip and the passive equalizer in the substrate are connected by the first connector and the second connector, so that the receiver impedance network and the passive equalizer work cooperatively, and a resistance value of the receiver impedance network is adjusted to implement a mechanism with an adjustable receiver bandwidth gain, thereby increasing a working frequency and meeting a high-speed SerDes interconnection requirement. In addition, compared with a conventional equalization circuit design, the passive equalizer in the equalization circuit is disposed outside the receiver chip and is connected to the first connector and the second connector, and therefore does not occupy additional package fan-out space or an additional chip area. The data transmission apparatus includes a printed circuit board and an package apparatus that is provided in this application and that is connected to the printed circuit board, so that the package apparatus can provide a higher working frequency on the printed circuit board, to meet a high-speed SerDes interconnection requirement. In addition, because a passive equalizer in the package apparatus does not occupy additional package fan-out space or an additional chip area, the package apparatus correspondingly occupies a smaller area on the printed circuit board.

**BRIEF DESCRIPTION OF DRAWINGS**

FIG. 1 is a schematic diagram of an embodiment of an equalization circuit according to an embodiment of this application;

FIG. 2 is an equivalent circuit diagram of FIG. 1 according to an embodiment of this application;

FIG. 3 is a schematic diagram of two implementations of a passive equalizer in an equalization circuit according to an embodiment of this application;

FIG. 4 is a schematic diagram of another embodiment of an equalization circuit according to an embodiment of this application falling under the scope of the claims;

FIG. 5 is an equivalent circuit diagram of FIG. 4 according to an embodiment of this application falling under the scope of the claims;

FIG. 6 is a simplified schematic diagram in which a receiver chip is connected to a impedance network without a passive equalizer according to an embodiment of this application;

FIG. 7 is a simplified schematic diagram in which a receiver chip is connected to a impedance network with a passive equalizer according to an embodiment of this application;

FIG. 8 is a curve diagram of performance analysis on equalization circuits according to an embodiment of this application;

FIG. 9a is a schematic diagram of an embodiment of an package apparatus according to an embodiment of this application falling under the scope of the claims;

FIG. 9b is an equivalent circuit diagram of FIG. 9a according to an embodiment of this application;

FIG. 10 is a schematic structural diagram of an embodiment of an inductor of an package apparatus according to an embodiment of this application;

FIG. 11 is a schematic structural diagram of a resistor of an package apparatus according to an embodiment of this application;

FIG. 12a is a schematic diagram of another embodiment of an package apparatus according to an embodiment of this application;

FIG. 12b is a schematic diagram of another embodiment of an inductor of an package apparatus according to an embodiment of this application;

FIG. 13 is a circuit diagram of a switched resistor network according to an embodiment of this application; and

FIG. 14 is a circuit diagram of a voltage-controlled resistor according to an embodiment of this application.

## DESCRIPTION OF EMBODIMENTS

In the specification, claims, and accompanying drawings of this application, the terms "first", "second", and so on are intended to distinguish between similar objects but do not necessarily indicate a specific order or sequence. It should be understood that the data termed in such a way are interchangeable in proper circumstances so that embodiments described herein can be implemented in other orders than the order illustrated or described herein. In addition, the terms "include", "have", or any other variant thereof are intended to cover a non-exclusive inclusion. For example, a process, a method, a system, a product, or a device that includes a series of steps or circuits is not necessarily limited to the steps or circuits that are expressly listed, but may include another step or circuit not expressly listed or inherent to the process, the method, the product, or the device. The circuit division in this application is merely logical division, and there may be another division during implementation in actual application. For example, a plurality of circuits may be combined or integrated into another system, or some features may be ignored or not performed. In addition, the displayed or discussed mutual couplings or direct couplings or communication connections may be implemented through some interfaces, and indirect couplings or communication connections between the modules may be implemented in electronic or another form. This is not limited in this application. In addition, circuits or sub-circuits described as separate components may be or may not be physically separated, or may be or may not be physical circuits, or may not be grouped into a plurality of circuit modules. Objectives of the solutions of this application may be achieved by selecting some or all of the circuits according to actual requirements.

With continuous evolution of two major SerDes communication protocol clusters, namely, IEEE and CEI, each currently has a complete protocol cluster for a single-channel 56 Gbps signal rate. In recent years, a communication protocol framework for next-generation 112 Gbps has been developed. In the framework, communication forms of ultra-short range USR and multi-chip module MCM both are related to an application scenario of packaging a plurality of chips in a package and implementing high-speed interconnection between the chips. A high-precision advanced packaging technology enables a packaging function to evolve from simple signal interconnection to a combination of signal interconnection and signal processing.

SerDes is a mainstream time division multiplexing (TDM) and point-to-point (P2P) serial communication technology. According to the technology, a plurality of low-speed parallel signals are converted into high-speed serial signals at a transmitter side, then transmitted through a transmission medium (an optical cable or a copper wire), and finally converted back into low-speed parallel signals at a receiver side. This point-to-point serial communication technology fully uses a channel capacity of the transmission medium, thereby reducing the numbers of required transmission channels and device pins, and greatly reducing communication costs.

When a plurality of chips work cooperatively, signal receiving and sending need to be implemented between the chips over a SerDes link. As a communication rate greatly increases, loss caused by a SerDes passive link significantly deteriorates signal quality at a receiver side (a receiver chip). An equalization technology is widely applied to high-speed SerDes communication to compensate for the channel loss. An equalizer is usually designed inside a chip, including a feedforward equalizer, a decision feedback equalizer, a continuous time linear equalizer, and the like, at the expense of an additional chip area and additional power consumption. In addition, a passive equalizer may be constructed outside the chip (on a PCB or inside a package) by a device such as a resistor, an inductor, or a capacitor. However, the passive equalizer currently mainly faces the following two problems: First, a working frequency is excessively low, and cannot meet a high-speed SerDes interconnection requirement. Second, fan-out space on the package or the PCB needs to be occupied to use the passive equalizer, and a fan-out density is reduced.

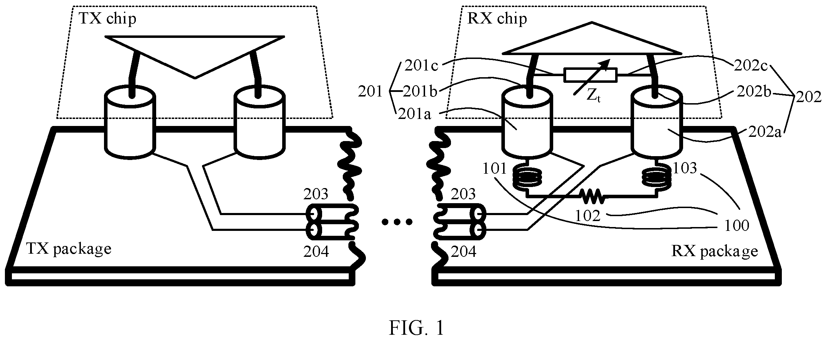

To resolve the foregoing problems, embodiments of this application provide an equalization circuit, an package apparatus, and a data transmission apparatus. A passive equalizer and a receiver impedance network cooperate to implement an equalization circuit with an adjustable gain and bandwidth, to increase a communication rate of a SerDes link. In addition, the passive equalizer is packaged outside a receiver chip, and therefore does not occupy a chip area. In addition, the passive equalizer is packaged below a connection point, and therefore does not occupy additional fan-out space, nor affects a fan-out density. For ease of understanding, the following describes a specific implementation of a technical solution of this application with reference to FIG. 1.

As shown in FIG. 1, an equalization circuit provided in this application includes a receiver impedance network $Z_t$ disposed inside a receiver chip RX, and a passive equalizer 100 disposed outside the receiver chip.

The receiver impedance network $Z_t$ is connected to the passive equalizer 100 by a first connector 201 and a second connector 202, and is connected to a first trace 203 and a second trace 204 of a differential trace by the first connector 201 and the second connector 202 respectively. The differential trace is configured to connect the receiver chip and a transmitter chip.

In this embodiment, the transmitter chip TX and the receiver chip RX are connected by the differential trace. The receiver impedance network $Z_t$ is disposed inside the receiver chip, and the passive equalizer 100 is disposed outside the receiver chip, thereby reducing a chip area. In addition, the passive equalizer 100 is connected to the receiver impedance network $Z_t$ by the first connector 201 and the second connector 202, and the receiver impedance network $Z_t$ cooperates with the passive equalizer 100 by adjusting a resistance value of the receiver impedance network $Z_t$ to form an overall structure of an equalization circuit with an adjustable gain and bandwidth, to adjust termination impedance matching and an overall link bandwidth.

It should be noted that the passive equalizer may be a passive equalizer provided in the embodiments of this application, or may be a passive equalizer in the conventional technology. The receiver chip may be a wafer die.

In this embodiment, the first trace 203 of the differential trace is a P trace of the differential trace, the second trace 204 of the differential trace is an N trace of the differential trace, and two ends of the passive equalizer 100 are respectively connected to the first connector 201 and the second connector 202, to implement parallel connection to the differential trace. The passive equalizer 100 has only two ports, and the two ports are respectively connected to the P trace and the N trace of the differential trace rather than grounded, thereby reducing signal amplitude loss in the equalization circuit and reducing direct current loss.

Further, the first connector 201 is connected to the first trace 203, and the second connector 202 is connected to the second trace 203. The first connector 201 includes a first bump 201a, a first pin 201b, and a first wire 201c. The second connector 202 includes a second bump 202a, a second pin 202b, and a second wire 202c. One end of the first bump 201a is connected to one end of the passive equalizer 100, the other end of the first bump 201a is connected to one end of the first pin 201b, the other end of the first pin 201b is connected to the receiver chip, and the first pin 201b is connected by the first wire 201c to the receiver impedance network $Z_t$ disposed inside the receiver chip. One end of the second bump 202a is connected to the other end of the passive equalizer 100, the other end of the second bump 202a is connected to one end of the second pin 202b, the other end of the second pin 202b is connected to the receiver chip, and the second pin 202b is connected by the second wire 202c to the receiver impedance network $Z_t$ disposed inside the receiver chip.

It should be noted that the first bump 201a and the second bump 202a may alternatively be directly connected to the receiver impedance network $Z_t$ without a pin or a wire, to implement connection to the receiver chip.

In this embodiment, the bump is a spherical/cylindrical metal that has a connection function in a flip chip package technology.

It should be noted that the connection between the passive equalizer 100 and the receiver impedance network $Z_t$ in the foregoing circuit may include two manners: parallel connection not falling under the scope of the claims and serial connection falling under the scope of the claims. For ease of understanding, the following specifically describes the two solutions.

1. The passive equalizer is connected in parallel to the receiver impedance network $Z_t$.

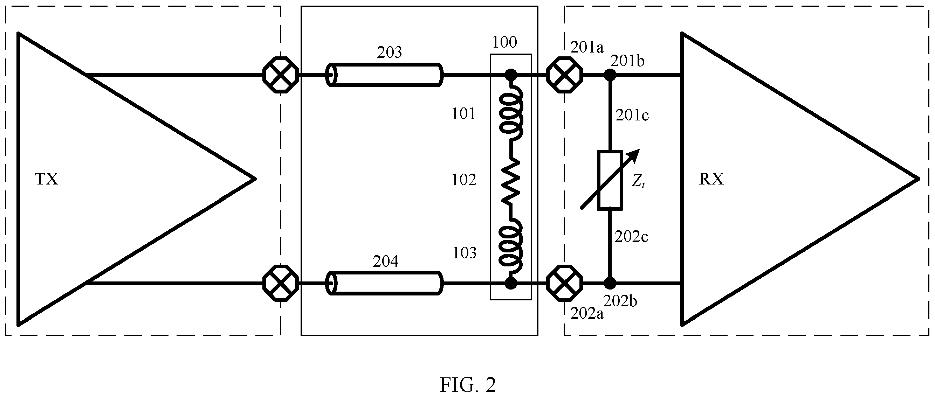

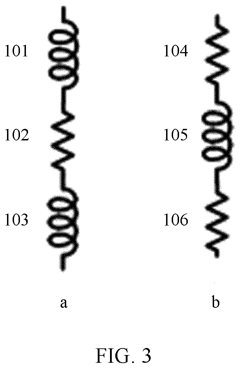

FIG. 1 is a schematic structural diagram in which the passive equalizer 100 is connected in parallel to the receiver impedance network $Z_t$, FIG. 2 is an equivalent circuit diagram of FIG. 1, and FIG. 3 shows two optional structures of the passive equalizer 100 in a parallel connection case.

When the passive equalizer 100 is connected in parallel to the receiver impedance network $Z_t$, the passive

equalizer 100 needs at least one resistor and at least one inductor to implement a function of the passive equalizer.

For example, as shown in FIG. 3, the passive equalizer 100 includes an inductor and a resistor. The passive equalizer 100 may be an L-R-L circuit including two inductors and one resistor, or may be an R-L-R circuit including two resistors and one inductor. The following separately describes the circuits in detail.

1. L-R-L circuit.

As shown in FIG. 1, FIG. 2, and a of FIG. 3, the L-R-L circuit structure of the passive equalizer 100 includes a first inductor 101, a first resistor 102, and a second inductor 103 that are sequentially disposed. A first end of the first inductor 101 is connected to the first connector 201, a second end of the first inductor 101 is connected to a first end of the first resistor 102, a second end of the first resistor 102 is connected to a first end of the second inductor 103, and a second end of the second inductor 103 is connected to the second connector 202.

2. R-L-R circuit.

As shown in b of FIG. 3, the R-L-R circuit structure of the passive equalizer 100 includes a second resistor 104, a third inductor 105, and a third resistor 106 that are sequentially disposed. A first end of the second resistor 104 is connected to the first connector 201, a second end of the second resistor 104 is connected to a first end of the third inductor 105, a second end of the third inductor 105 is connected to a first end of the third resistor 106, and a second end of the third resistor 106 is connected to the second connector 202. A specific manner of disposing the R-L-R circuit is the same as that shown in FIG. 1 and FIG. 2, except that positions of the inductors and the resistors are exchanged. Therefore, details are not described in the drawing.

In this embodiment, both the L-R-L circuit and the R-L-R circuit can implement a function of the passive equalizer 100. As shown in FIG. 1, the two ends of the passive equalizer 100 are respectively connected to the first connector 201 and the second connector 202, and the two ends of the receiver impedance network $Z_t$ are also respectively connected to the first connector 201 and the second connector 202, so that the passive equalizer 100 and the receiver impedance network $Z_t$ are connected in parallel. In this implementation, only two connectors are needed to connect the passive equalizer 100 and the receiver impedance network $Z_t$ in parallel, and a mounting manner is simple.

2. The passive equalizer is connected in series to the receiver impedance network $Z_t$.

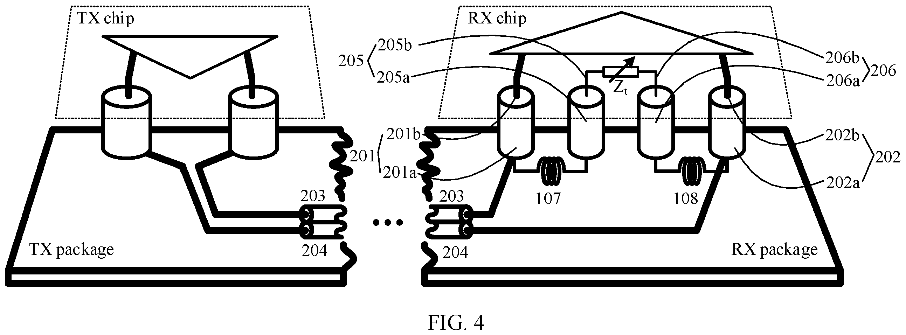

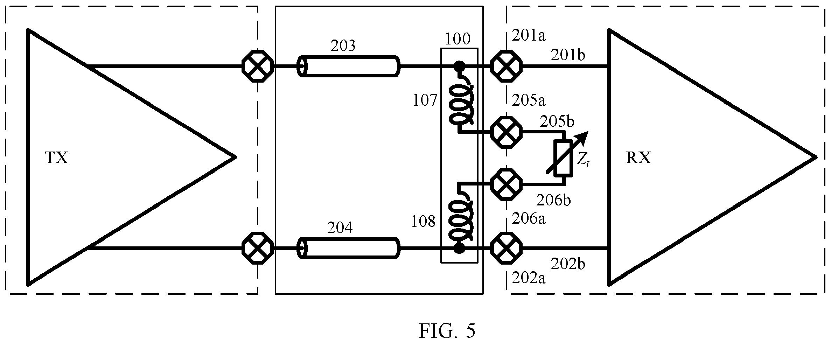

FIG. 4 is a structural diagram in which the passive equalizer 100 is connected in series to the receiver impedance network $Z_t$, and FIG. 5 is an equivalent circuit diagram of FIG. 4.

When the passive equalizer 100 is connected in series to the receiver impedance network $Z_t$, the passive equalizer 100 needs only at least one inductor, and the receiver impedance network $Z_t$ in serial connection can implement a resistor function of the passive equalizer, so that the passive equalizer 100 works normally.

For example, as shown in FIG. 4 and FIG. 5, the passive equalizer 100 connected in series to the receiver impedance network $Z_t$ includes a fourth inductor 107 and a fifth inductor 108. A first end of the fourth inductor 107 is connected to the first connector 201, a second end of the fourth inductor 107 is connected to a first end of the receiver impedance network $Z_t$ by a third connector 205, a second end of the receiver impedance network $Z_t$ is connected to a first end of the fifth inductor 108 by a fourth connector 206, and a second end of the fifth inductor 108 is connected to the second connector 202.

In this embodiment, the first connector 201 includes only the first bump 201a and the first pin 201b, the second connector 202 includes only the second bump 202a and the second pin 202b, the third connector 205 includes a third bump 205a and a third wire 205b, and the fourth connector 206 includes a fourth bump 206a and a fourth wire 206b. One end of the third bump 205a is connected to the fourth inductor 107, and the other end is connected to the receiver impedance network $Z_t$ by the third wire 205b. One end of the fourth bump 206a is connected to the fifth inductor 108, and the other end is connected to the receiver impedance network $Z_t$ by the fourth wire 206b.

In this embodiment, the two inductors in the passive equalizer 100 are connected in series to the receiver impedance network $Z_t$, so that the receiver impedance network $Z_t$ becomes a part of the passive equalizer 100 and functions as a resistor, and the passive equalizer 100 can work cooperatively with the receiver impedance network $Z_t$, thereby saving a resistor, and fully using a resistor function of the receiver impedance network $Z_t$.

In the foregoing two embodiments, the first connector 201 and the second connector 202 are connection points between the differential trace and the receiver chip, and the passive equalizer 100 is connected to the first connector 201 and the second connector 202. This reduces fan-out space occupied by the passive equalizer 100, and does not affect a fan-out density.

It should be noted that, the description about the numbers of inductors and resistors in the passive equalizer 100 is only an example. The passive equalizer 100 includes at least one inductor. When the passive equalizer 100 is connected in parallel to the receiver impedance network $Z_t$, the passive equalizer 100 further includes at least one resistor. The specific numbers of inductors and resistors are not limited in the embodiments of this application. Any number falls within the protection scope claimed in the embodiments of this application, provided that the passive equalizer 100 and the receiver impedance network $Z_t$ are connected in the foregoing manners.

In the foregoing two embodiments, impedance of the receiver impedance network $Z_t$ is adjusted to control input impedance of a receiver chip and adjust performance of the equalization circuit. The following analyzes performance of the connection between the passive equalizer 100 and the receiver impedance network $Z_t$.

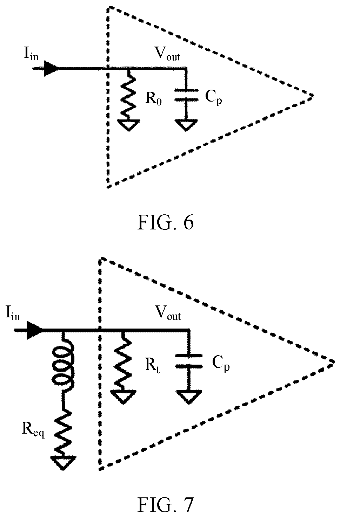

A diagram in which a receiver chip is connected to a impedance network without a passive equalizer is shown in FIG. 6 (a differential network is changed to a single-sided half network for analysis). The network may be simplified into a resistor-capacitor network. $R_0$ is a terminating resistor (which usually needs to match characteristic impedance of a channel, $R_0 = 50$ 0hm). $C_p$ is not a capacitor added artificially, but a parasitic capacitor caused by a wiring/device structure. The parasitic capacitor greatly affects an overall bandwidth. As shown in FIG. 6, impedance network impedance $Z(s)$ of the receiver chip is defined as follows:

$$Z(s) = \frac{V_{out}}{I_{in}} = \left(\frac{1}{sC}\right) \| R_0 = \frac{\frac{1}{sC} \cdot R_0}{\frac{1}{sC} + R_0} = \frac{R_0}{1 + sCR_0}$$

$I_{in}$ represents an input current, $V_{out}$ represents an output voltage, $R_0$ may be equivalent to the receiver impedance network $Z_t$, s represents a frequency, and C represents a capacitance value of $C_p$ in FIG. 4.

It can be learned from the foregoing formula that, $Z(s)$ is a value that varies with the frequency. When s = 0 (in a DC case), $Z(s)$ has a maximum value, that is, $Z(0) = R_0$. This value is defined as a direct current gain of the network, and this value determines a maximum voltage amplitude of a signal. As s increases (the frequency increases), $Z(s)$ decreases gradually and tends to 0. A 3 dB bandwidth (BW, bandwidth) of the network is defined as follows: When $Z(s)$

$$Z(s) = \frac{Z(0)}{\sqrt{2}}, -3 \text{ dB} = 1/\sqrt{2}$$

decreases by 3 dB, that is,                                                                 .

FIG. 7 shows a simplified network model of a receiver chip with the passive equalizer 100 (or referred to as an inductor-resistor network). Impedance $Z(s)$ of the network shown in FIG. 7 is calculated as follows:

$$Z(s) = \frac{V_{out}}{I_{in}} = \left(\frac{1}{sC}\right) \| R_t \| (sL + R_{eq}) = \frac{\frac{1}{sC} \cdot R_t \cdot (sL + R_{eq})}{\frac{1}{sC}R_t + \frac{1}{sC}(sL + R_{eq}) + R_t(sL + R_{eq})}$$

$$= \frac{R_t L \cdot s + R_t R_{eq}}{LCR_t \cdot S^2 + (L + CR_{eq}R_t) \cdot s + (R_t + R_{eq})}$$

$I_{in}$ represents an input current, $V_{out}$ represents an output voltage, $R_t$ may be equivalent to the receiver impedance network $Z_t$, s represents a frequency, C represents a capacitance value of $C_p$ in FIG. 7, L represents an inductance value of an inductor in the passive equalizer 100, and $R_{eq}$ represents a resistance value of a resistor in the passive equalizer 100.

It can be learned from the foregoing formula that, the resistance value $R_t$ of the receiver impedance network and the resistance value $R_{eq}$ and $R_t$ of the passive equalizer 100 are adjusted, so that $R_t \| R_{eq} = \frac{R_t \cdot R_{eq}}{R_t + R_{eq}} = R_0$ .

In this case, $Z(0) = R_t \| R_{eq} = R_0$, a direct current gain of the network remains unchanged, and a maximum voltage amplitude of a signal remains unchanged. In addition, the bandwidth increases by 3 dB after the inductor-resistor passive equalizer 100 is added.

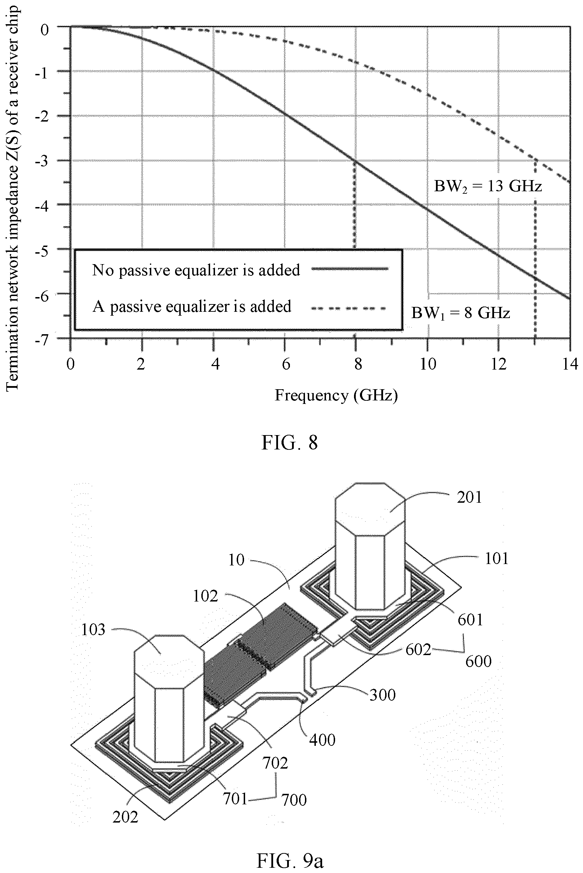

FIG. 8 shows change curves of a frequency and $Z(s)$ when the passive equalizer 100 is added and when the passive equalizer 100 is not added. $BW_1$ is a change curve of s and $Z(s)$ when the passive equalizer 100 is not added, and $BW_2$ is a change curve of s and $Z(s)$ after the passive equalizer 100 is added. It can be learned from FIG. 6 that, for example, when $Z(s)$ is -3 dB, $BW_1 = 8$ GHz and $BW_2 = 13$ GHz. It can be learned that after the passive equalizer 100 is added, a working frequency is higher under same impedance network impedance. That is, the passive equalizer 100 can be added to increase an overall operating bandwidth, thereby increasing a working frequency and meeting a high-speed SerDes interconnection requirement.

The foregoing describes a circuit structure of the equalization circuit of this application, and analyzes performance of the circuit structure.

Further, the inductor is a spiral inductor, and the resistor is a package-embedded high-density metal resistor. Optionally, the resistor may alternatively be an SMD resistor or a film resistor. The receiver impedance network is a switched resistor network or a voltage-controlled resistor.

An embodiment of this application further provides an package apparatus. The package apparatus includes the foregoing equalization circuit structure. The foregoing solution includes two connection solutions: parallel connection and serial connection between the passive equalizer 100 and the receiver impedance network $Z_t$. The technical solution of parallel connection can be implemented by only two connectors, and therefore has a more simplified mounting process and higher efficiency. Therefore, a specific implementation of the package apparatus provided in this embodiment of this application is described below by the technical solution in which the passive equalizer 100 is connected in parallel to the receiver impedance network $Z_t$ as an example.

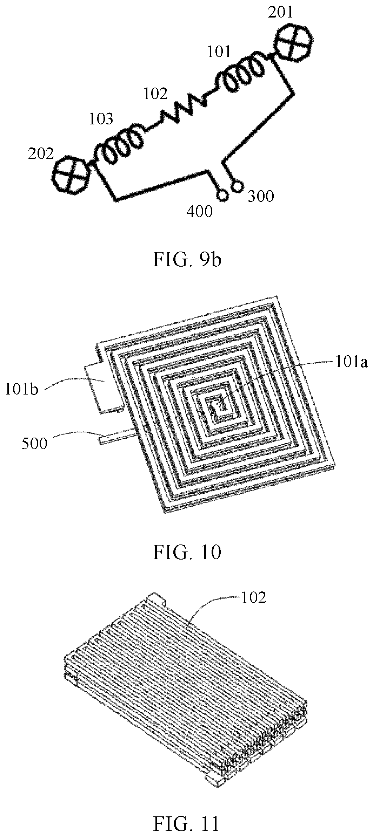

FIG. 9a is a schematic structural diagram of an package apparatus according to an embodiment of this application, and FIG. 9b is an equivalent circuit diagram of FIG. 9a. On a silicon-based package, because a line width, a line spacing, and a via size may all be precisely controlled (typically to a process precision below 1 $\mu$m), a resistor and an inductor may be constructed in different cabling modes, as shown in FIG. 9a. The passive equalizer 100 of the L-R-L structure is used as an example.

As shown in FIG. 9a, the package apparatus provided in this embodiment of this application includes a receiver chip (not shown in FIG. 9a) and a substrate 10. The receiver chip is disposed on a side of the substrate and is connected to the substrate. A passive equalizer 100 is disposed in the substrate 10. A receiver impedance network is disposed in the receiver chip. The receiver impedance network is connected to the passive equalizer 100 by a first connector 201 and a second connector 202, and is connected to a first trace and a second trace of a differential trace by the first connector 201 and the second connector 202 respectively. The differential trace is configured to connect the receiver chip and a transmitter chip.

In this embodiment, a first inductor 101 is disposed at the bottom of the first connector 201, a second inductor 103 is disposed at the bottom of the second connector 202, a first resistor 102 is disposed between the first connector 201 and the second connector 202, and two ends of the first resistor 102 are respectively connected to the first inductor 101 and the second inductor 103. The receiver chip is connected to the first connector 201 and the second connector 202 from the top. A first pin 300 and a second pin 400 are respectively disposed on the first inductor 101 and the second inductor 103. The first trace and the second trace of the differential trace are respectively connected to the first pin 300 and the second pin 400. During specific operation, a high-speed signal passes through the first pin 300 and the second pin 400 over the differential trace, then enters the passive equalizer 100, and finally flows into an input end of the receiver chip through the first connector 201 and the second connector 202. An equivalent circuit model of the entire passive equalizer 100 is shown in FIG. 9b. It can be learned that a circuit structure in FIG. 9b is the circuit structure in FIG. 1.

It should be noted that the first connector 201 and the second connector 202 are connection points provided only with a bump bump. Further, the bump may be connected to the receiver chip by a pin and a wire.

Further, the first inductor 101, the second inductor 103, and the second resistor 102 are all disposed on a surface of the substrate 10 that faces the receiver chip. For example, the first inductor 101 is disposed in close contact with the first connector 201, and the second inductor is disposed in close contact with the second connector 202.

In a common fan-out manner in which a high-speed signal cable is packaged in the conventional technology, a differential trace is disposed in a region between bumps, and usually, no other signal cables are placed between the bumps, to maintain integrity of a high-speed signal, and eliminate signal interference to the high-speed signal. This correspondingly results in a waste of area used by the equalization circuit on the substrate 10. In this embodiment, the inductor is disposed at an end of the connector by packaging, and the resistor is disposed between the bumps in series. Such a centralized placement method utilizes a wasted position between the bumps, thereby greatly reducing an area occupied by the equalization circuit on the substrate 10, while original signal fan-out space is almost unaffected.

It should be noted that, the foregoing package apparatus is merely an example. When the passive equalizer 100 is connected in parallel to the receiver impedance network $Z_t$, the passive equalizer 100 may alternatively be the foregoing R-L-R structure, and a difference from the technical solution shown in FIG. 9a is that the inductor and the resistor are replaced. Details are not described herein again. Further, in the foregoing package apparatus, the passive equalizer 100 and the receiver impedance network $Z_t$ may alternatively be connected in series, as shown in FIG. 4. Details are not described herein again.

Further, the transmitter chip and the receiver chip may be disposed on a same substrate. In this case, the transmitter chip and the receiver chip are disposed in a same package apparatus, and the transmitter chip is disposed on a side of the substrate that faces the receiver chip. The transmitter chip and the receiver chip are connected by the differential trace, and the differential trace is disposed in the substrate. Alternatively, the transmitter chip is disposed in another package apparatus, and the transmitter chip is connected to the receiver chip by the differential trace.

It should be further noted that the foregoing package apparatus is at least one of a silicon-based package, an organic resin material package, a fan-out package, or a glass package. This is not limited in the technical solutions of this application. Any package falls within the protection scope of the embodiments of this application provided that the equalization circuit is implemented in the foregoing manner. Further, the technical solution of the foregoing circuit has different implementations for different package types, which specifically include two implementations, namely, a silicon-based/organic resin material package, and a fan-out package, as example embodiments. The following separately describes the implementations.

1. Silicon-based/Organic resin package.

A structure of the first inductor 101 is shown in FIG. 10. The first inductor 101 is a spiral inductor, the first inductor 101 is a spiral-shaped structure formed by a spiral metal wire, and the spiral-shaped structure includes a center tap 101a and an end tap 101b. The end tap 101b is connected to the first bump 201a in the first connector 201, a lead 500 is connected to the center tap 101a, the other end of the lead 500 is connected to the first resistor 102, and the other end of the first resistor 102 is connected to the second inductor 103 by a lead the same as the lead 500. Further, the end tap 101b is connected to the first pin 300 shown in FIG. 9a.

It should be noted that a shape of the spiral-shaped structure of the first inductor 101 may be a rectangle shown in FIG. 10, or may be a circular shape or another shape. This is not limited in this embodiment of this application.

Further, as shown in FIG. 9a, a first thick metal trace layer 600 for packaging is disposed at a connection point between the first inductor 101 and the first connector 201, and the first thick metal trace layer 600 is formed by winding a metal wire, and includes a first body 601 and a first protrusion 602 that are integrally disposed. The first body 601 is disposed at the bottom of the first connector 201. Specifically, the first connector 201 is bonded to the bottom of the first body 601. The first protrusion 602 is connected to the end tap 101b. Specifically, the first protrusion 602 is bonded to the end tap 101b. In this way, the first thick metal trace layer 600 connects the first connector 201 and the first inductor 101.

During specific operation, the first thick metal trace layer 600 implements stable integrated packaging among the first inductor 101, the connection point, and the first pin 300 by a silicon-based package or an organic resin material package.

Symmetrically, a manner of disposing the second inductor 103 is the same as that of the first inductor 101. A second thick metal trace layer 700 is disposed at a connection point between the second inductor 103 and the second connector 202, and includes a second body 701 and a second protrusion 702. Manners of disposing the second body 701 and the second protrusion 702 are the same as those described above. Details are not described herein again.

Further, a structure of the first resistor 102 is shown in FIG. 11, and the first resistor 102 is a package-embedded high-density metal resistor, and is implemented by a trace parasitic resistor. Through high-density winding, an extremely large trace length is achieved in a relatively small region, thereby obtaining considerable trace resistance. In the example of FIG. 9a, the first resistor 102 is formed by connecting symmetrical left and right parts in series. Optionally, the first resistor 102 may alternatively be implemented as an integral resistor without being divided into symmetrical left and right parts. In an alternative solution, the first resistor 102 may alternatively be an SMD resistor or a film resistor.

It should be noted that the spiral inductor and the package-embedded high-density metal resistor may be disposed on the substrate 10 through etching. This is not limited in this embodiment of this application.

The foregoing technical solution provides an implementation of a silicon-based package or an organic resin material package, which packages, as a common packaging manner, the equalization circuit into an package apparatus.

2. Fan-out package.

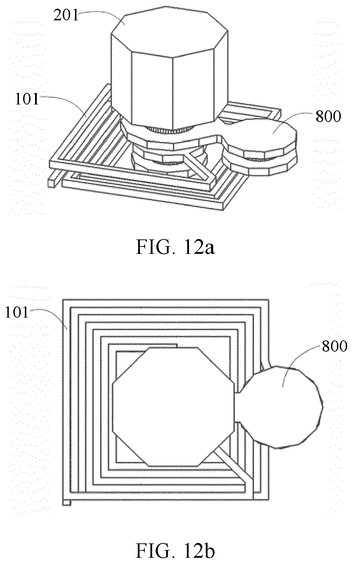

Refer to FIG. 12a and FIG. 12b. On a high-precision organic package (for example, a FoP fan-out package form), the package apparatus provided in this embodiment of this application may also be implemented in a manner similar to that described above. As shown in FIG. 12a, the connection between the first connector 201 and the first inductor 101 is still used as an example. A structure of the first inductor 101 is shown in FIG. 12b, which is the same as the structure shown in FIG. 10, and details are not described herein again. A spiral-shaped center tap of a spiral-shaped structure is disposed at the center tap of the spiral-shaped structure of the first inductor 101, the spiral-shaped structure of the first inductor 101 has different RDL layers of metal traces, and the first inductor 101 and the first connector 201 are connected by a third thick metal trace layer 800.

A manner of disposing the second inductor 103 and the second connector 202 is the same as that described above, and details are not described herein again.

It should be noted that a specific physical structure of the foregoing equalization circuit is described by a case in which the passive equalizer 100 of the L-R-L circuit structure is connected in parallel to the receiver impedance network $Z_t$. When the passive equalizer 100 is connected in parallel to the receiver impedance network $Z_t$, the passive equalizer 100 uses the implementation solution of the R-L-R circuit structure, which requires only to exchange the inductor and the resistor in the foregoing embodiment. A specific implementation is replacing the first inductor 101 with the second resistor 104, replacing the second inductor 103 with the third resistor 106, and replacing the first resistor 102 with the third inductor 105. Details are not described in this embodiment of this application again. When the passive equalizer 100 is connected in series to the receiver impedance network $Z_t$, the first inductor 101 is connected to the receiver impedance network $Z_t$ by the third connector 203, and the second inductor 103 is connected to the receiver impedance network $Z_t$ by the fourth connector 204. Manners of disposing other components are the same as those described above, and details are not described herein again.

It should be noted that, the receiver impedance network $Z_t$ in the foregoing embodiment may be implemented in a plurality of manners, which is not limited in this embodiment of this application. In an example implementation, the receiver impedance network $Z_t$ may be a switched resistor network or a voltage-controlled resistor. For ease of understanding, the following separately describes the implementations with reference to accompanying drawings.

1. Switched resistor network.

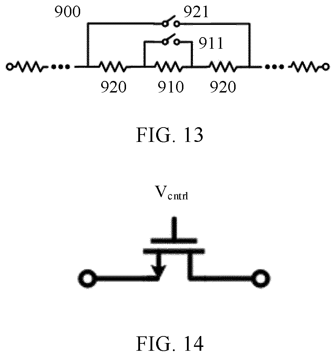

An implementation in which the receiver impedance network $Z_t$ is implemented by a switched resistor network 900 is shown in FIG. 13, including one first-stage resistor 910 and two second-stage resistors 920. The first-stage resistor 910 is disposed between the two second-stage resistors 920. A first switch 911 is connected in parallel to the first-stage resistor 910, and a second switch 921 is connected in parallel to the two second-stage resistors 920. When the first switch 911 is open, the first-stage resistor 910 works. When the first switch is closed, a current flows through the first-stage switch, and the first-stage resistor 910 does not work. When the second switch 921 is open, the two second-stage resistors 920 work. When the second switch is closed, a current flows through the second switch, and the two second-stage resistors 920 do not work. Further, the switched resistor network may be further provided with a third-stage resistor, a fourth-stage resistor, ..., and an $N^{th}$-stage resistor, and correspondingly provided with a third switch, a fourth switch..., and an $N^{th}$ switch, to adjust a resistance value of the switched resistor network by the switches.

In this embodiment, work of the receiver impedance network $Z_t$ is implemented in a form of the switched resistor network, so that an operation manner is simple, and the resistance value of the receiver impedance network $Z_t$ can be precisely controlled.

2. Voltage-controlled resistor.

An implementation in which the receiver impedance network $Z_t$ is implemented by a voltage-controlled resistor is shown in FIG. 14, including a voltage-controlled resistor $V_{cntrl}$. In this way, a resistance value of the receiver impedance network $Z_t$ is adjusted in a form of a transistor, a volume is smaller, and a resistance adjustment range is large, making it more conducive to reducing an occupied chip area.

This application further provides a data transmission apparatus, including a printed circuit board and an package apparatus connected to the printed circuit board. The package apparatus may be the package apparatus in any one of FIG. 9 to FIG. 14.

It should be understood that the transmitter chip and the receiver chip mentioned in the embodiments of this application may include a central processing unit (CPU), and may further include another general-purpose processor, a digital signal processor (DSP), an application-specific integrated circuit (ASIC), a field programmable gate array (FPGA), or another programmable logic device, discrete gate or transistor logic device, discrete hardware component, or the like. The general-purpose processor may be a microprocessor, or the processor may be any conventional processor or the like.

In the several embodiments provided in this application, it should be understood that the disclosed circuits, apparatus, and package may be implemented in other manners. For example, the described apparatus embodiment is merely an example. For example, the circuit division is merely logical function division and may be other division in actual implementation. For example, a plurality of circuits or components may be combined or integrated into another system, or some features may be ignored or not performed. In addition, the displayed or discussed mutual couplings or direct couplings or communication connections may be implemented through some interfaces. The indirect couplings or communication connections between the apparatuses or circuits may be implemented in electronic, mechanical, or other forms.

The circuits described as separate parts may be or may not be physically separate, and parts displayed as circuits may be or may not be physical circuits, may be located in one position, or may be distributed on a plurality of network circuits. Some or all of the circuits may be selected based on actual requirements to achieve the objectives of the solutions of the embodiments.

In addition, functional circuits in the embodiments of this application may be integrated into one processing circuit, or each of the circuits may exist alone physically, or two or more circuits may be integrated into one circuit. The foregoing integrated circuit may be implemented in a form of hardware, or may be implemented in a form of a software functional circuit. When the integrated circuit is implemented in the form of a software functional circuit and sold or used as an independent product, the integrated circuit may be stored in a computer-readable storage medium.

It should be understood that sequence numbers of the foregoing processes do not mean execution sequences in various embodiments of this application, and some or all of the steps may be performed in parallel or sequentially. The execution sequences of the processes should be determined according to functions and internal logic of the processes, and should not be construed as any limitation on the implementation processes of the embodiments of this application.

It may be clearly understood by a person skilled in the art that, for the purpose of convenient and brief description, for a specific structure of the foregoing circuits, apparatus and package, reference may be made to a corresponding structure in the foregoing embodiments, and details are not described herein again.

For related parts between the structural embodiments of this application, reference may be made to each other. The apparatus provided in each apparatus embodiment is configured to execute the circuit provided in the corresponding circuit embodiment. Therefore, each apparatus embodiment may be understood with reference to a related part in the related circuit embodiment.

The apparatus structure diagrams provided in the apparatus embodiments of this application show only a simplified design of a corresponding apparatus. During actual application, the apparatus may include any number of transmitters, receivers, processors, memories, or the like, to implement functions or operations performed by the apparatus in the apparatus embodiments of this application. All apparatuses that can implement this application fall within the protection scope of this application.

The terms used in the embodiments of this application are merely for the purpose of illustrating specific embodiments, and are not intended to limit this application. The terms "a", "said" and "the" of singular forms used in the embodiments and the appended claims of this application are also intended to include plural forms, unless otherwise specified in the context clearly. In addition, the character "/" in this application generally indicates an "or" relationship between the associated objects.

The technical solutions provided in this application are described in detail above. The principle and implementation of this application are described herein through specific examples. The description about the embodiments is merely provided to help understand the method and core ideas of this application. In addition, a person of ordinary skill in the art can make variations and modifications to this application in terms of the specific implementations and application scopes according to the ideas of this application. Therefore, the content of specification shall not be construed as a limit to this application.

## Claims

1. An equalization circuit comprising:

   • a receiver impedance network ($Z_t$) disposed inside a receiver chip (RX),
   • a passive equalizer (100) disposed outside the receiver chip (RX), the passive equalizer (100) containing a first inductor (107) and a second inductor (108),
   • a first connector (201), a second connector (202), a third connector (205), and a fourth connector (206), wherein the structures of the first connector (201), the second connector (202), the third connector (205), and the fourth connector (206) are the same,
   • wherein:

      ◦ the receiver chip (RX) is connected to the passive equalizer (100) by the first connector (201) and the second connector (202), and is connected to a first trace (203) and a second trace (204) of a differential trace by the first connector (201) and the second connector (202) respectively, wherein the differential trace is configured to connect the receiver chip (RX) and a transmitter chip (TX), and **characterized in that**
      ◦ a first end of the first inductor (107) is connected to the first connector (201), a second end of the first inductor (107) is connected to a first end of the receiver impedance network ($Z_t$) by the third connector (205), a second end of the receiver impedance network ($Z_t$) is connected to a first end of the second inductor (108) by the fourth connector (206), and a second end of the second inductor (108) is connected to the second connector (202); and
      ◦ the first end of the first inductor (107) is further connected to the first trace (203), and the second end of the second inductor (108) is further connected to the second trace (204).

2. The circuit according to claim 1, wherein the first connector comprises a first bump, one end of the first bump is connected to a first end of the passive equalizer, and the other end of the first bump is connected to the receiver chip; and the second connector comprises a second bump, one end of the second bump is connected to a second end of the passive equalizer, and the other end of the second bump is connected to the receiver chip.

3. The circuit according to claim 2, wherein the first connector further comprises a first pin and a first wire, a first end of the first pin is connected to the first bump, a second end of the first pin is connected to the receiver chip, and the second end of the first pin is connected to the first end of the receiver impedance network by the first wire; and the second connector further comprises a second pin and a second wire, a first end of the second pin is connected to the second bump, a second end of the second pin is connected to the receiver chip, and the second end of the second pin is connected to the second end of the receiver impedance network by the second wire.

4. A package apparatus, wherein the package apparatus comprises:

   • a receiver chip (RX),
   • a substrate (10), the receiver chip (RX) being disposed on a side of the substrate (10) and is connected to the substrate (10), and
   • an equalization circuit according to anyone of claims 1-3, wherein the passive equalizer (100) is disposed in the substrate (10), and the receiver impedance network ($Z_t$) is disposed in the receiver chip (RX).

5. A data transmission apparatus, wherein the data transmission apparatus comprises a printed circuit board and the package apparatus according to claim 4, the package apparatus being connected to the printed circuit board.


**Patentansprüche**

1. Entzerrungsschaltung, die umfasst:

   • ein Empfängerimpedanznetzwerk ($Z_t$), das innerhalb eines Empfängerchips (RX) angeordnet ist,
   • einen passiven Entzerrer (100), der außerhalb des Empfängerchips (RX) angeordnet ist, wobei der passive Entzerrer (100) einen ersten Induktor (107) und einen zweiten Induktor (108) enthält,
   • einen ersten Verbinder (201), einen zweiten Verbinder (202), einen dritten Verbinder (205) und einen vierten Verbinder (206), wobei die Strukturen des ersten Verbinders (201), des zweiten Verbinders (202), des dritten Verbinders (205) und des vierten Verbinders (206) gleich sind,
   • wobei:

      ◦ der Empfängerchip (RX) mit dem passiven Entzerrer (100) durch den ersten Verbinder (201) und den zweiten Verbinder (202) verbunden ist und mit einer ersten Spur (203) und einer zweiten Spur (204) einer Differenzspur durch den ersten Verbinder (201) beziehungsweise den zweiten Verbinder (202) verbunden ist, wobei die Differenzspur konfiguriert ist, um den Empfängerchip (RX) und einen Übertragungschip (TX) zu verbinden, und **dadurch gekennzeichnet, dass**
      ◦ ein erstes Ende des ersten Induktors (107) mit dem ersten Verbinder (201) verbunden ist, ein zweites Ende des ersten Induktors (107) mit einem ersten Ende des Empfängerimpedanznetzwerks ($Z_t$) durch den dritten Verbinder (205) verbunden ist, ein zweites Ende des Empfängerimpedanznetzwerks (Zt) mit einem ersten Ende des zweiten Induktors (108) durch den vierten Verbinder (206) verbunden ist und ein zweites Ende des zweiten Induktors (108) mit dem zweiten Verbinder (202) verbunden ist; und
      ◦ das erste Ende des ersten Induktors (107) ferner mit der ersten Spur (203) verbunden ist und das zweite Ende des zweiten Induktors (108) ferner mit der zweiten Spur (204) verbunden ist.

2. Schaltung nach Anspruch 1, wobei der erste Verbinder eine erste Erhebung umfasst, ein Ende der ersten Erhebung mit einem ersten Ende des passiven Entzerrers verbunden ist und das andere Ende der ersten Erhebung mit dem Empfängerchip verbunden ist; und der zweite Verbinder eine zweite Erhebung umfasst, wobei ein Ende der zweiten Erhebung mit einem zweiten Ende des passiven Entzerrers verbunden ist und das andere Ende der zweiten Erhebung mit dem Empfängerchip verbunden ist.

3. Schaltung nach Anspruch 2, wobei der erste Verbinder ferner einen ersten Stift und einen ersten Draht umfasst, ein erstes Ende des ersten Stifts mit der ersten Erhebung verbunden ist, ein zweites Ende des ersten Stifts mit dem Empfängerchip verbunden ist und das zweite Ende des ersten Stifts durch den ersten Draht mit dem ersten Ende des Empfängerimpedanznetzwerks verbunden ist; und der zweite Verbinder ferner einen zweiten Stift und einen zweiten Draht umfasst, wobei ein erstes Ende des zweiten Stifts mit der zweiten Erhebung verbunden ist, ein zweites Ende des zweiten Stifts mit dem Empfängerchip verbunden ist und das zweite Ende des zweiten Stifts durch den zweiten Draht mit dem zweiten Ende des Empfängerimpedanznetzwerks verbunden ist.

**4.** Paketeinrichtung, wobei die Paketeinrichtung umfasst:

• einen Empfängerchip (RX),
• ein Substrat (10), wobei der Empfängerchip (RX) auf einer Seite des Substrats (10) angeordnet ist und mit dem Substrat (10) verbunden ist, und
• eine Entzerrungsschaltung nach einem der Ansprüche 1 bis 3, wobei der passive Entzerrer (100) in dem Substrat (10) angeordnet ist und das Empfängerimpedanznetzwerk ($Z_t$) in dem Empfängerchip (RX) angeordnet ist.

**5.** Datenübertragungseinrichtung, wobei die Datenübertragungseinrichtung eine Leiterplatte und die Paketeinrichtung nach Anspruch 4 umfasst, wobei die Paketeinrichtung mit der Leiterplatte verbunden ist.

**Revendications**

**1.** Circuit d'égalisation comprenant :

• un réseau d'impédance de réception (Zt) disposé à l'intérieur d'une puce de réception (RX),
• un égaliseur passif (100) disposé à l'extérieur de la puce de réception (RX), l'égaliseur passif (100) contenant une première bobine d'inductance (107) et une seconde bobine d'inductance (108),
• un premier connecteur (201), un deuxième connecteur (202), un troisième connecteur (205), et un quatrième connecteur (206), dans lequel les structures du premier connecteur (201), du deuxième connecteur (202), du troisième connecteur (205), et du quatrième connecteur (206) sont identiques,
• dans lequel :

◦ la puce de réception (RX) est connectée à l'égaliseur passif (100) par le premier connecteur (201) et le deuxième connecteur (202), et est connectée à une première trace (203) et à une seconde trace (204) d'une trace différentielle par le premier connecteur (201) et le deuxième connecteur (202) respectivement, dans lequel la trace différentielle est configurée pour connecter la puce de réception (RX) et une puce d'émission (TX), et **caractérisé en ce que**
◦ une première extrémité de la première bobine d'inductance (107) est connectée au premier connecteur (201), une seconde extrémité de la première bobine d'inductance (107) est connectée à une première extrémité du réseau d'impédance de réception ($Z_t$) par le troisième connecteur (205), une seconde extrémité du réseau d'impédance de réception ($Z_t$) est connectée à une première extrémité de la seconde bobine d'inductance (108) par le quatrième connecteur (206), et une seconde extrémité de la seconde bobine d'inductance (108) est connectée au deuxième connecteur (202) ; et
◦ la première extrémité de la première bobine d'inductance (107) est en outre connectée à la première trace (203), et la seconde extrémité de la seconde bobine d'inductance (108) est en outre connectée à la seconde trace (204).

**2.** Circuit selon la revendication 1, dans lequel le premier connecteur comprend une première bosse, une extrémité de la première bosse est connectée à une première extrémité de l'égaliseur passif, et l'autre extrémité de la première bosse est connectée à la puce de réception ; et le deuxième connecteur comprend une seconde bosse, une extrémité de la seconde bosse est connectée à une seconde extrémité de l'égaliseur passif, et l'autre extrémité de la seconde bosse est connectée à la puce de réception.

**3.** Circuit selon la revendication 2, dans lequel le premier connecteur comprend en outre une première broche et un premier fil, une première extrémité de la première broche est connectée à la première bosse, une seconde extrémité de la première broche est connectée à la puce de réception, et la seconde extrémité de la première broche est connectée à la première extrémité du réseau d'impédance de réception par le premier fil ; et le deuxième connecteur comprend en outre une seconde broche et un second fil, une première extrémité de la seconde broche est connectée à la seconde bosse, une seconde extrémité de la seconde broche est connectée à la puce de réception, et la seconde extrémité de la seconde broche est connectée à la seconde extrémité du réseau d'impédance de réception par le second fil.

**4.** Appareil de boîtier, dans lequel l'appareil de boîtier comprend :

• une puce de réception (RX),

• un substrat (10), la puce de réception (RX) étant disposée sur un côté du substrat (10) et est connectée au substrat (10), et

• un circuit d'égalisation selon l'une quelconque des revendications 1 à 3, dans lequel l'égaliseur passif (100) est disposé dans le substrat (10) et le réseau d'impédance de réception ($Z_t$) est disposé dans la puce de réception (RX).

5. Appareil de transmission de données, dans lequel l'appareil de transmission de données comprend une carte de circuit imprimé et l'appareil de boîtier selon la revendication 4, l'appareil de boîtier étant connecté à la carte de circuit imprimé.

FIG. 1

FIG. 2

101

102

103

104

105

106

a

b

FIG. 3

FIG. 4

FIG. 5

FIG. 6

FIG. 7

FIG. 8

FIG. 9a

FIG. 9b

FIG. 10

FIG. 11

FIG. 12a

FIG. 12b

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012139669 A1
- US 2004071219 A1
- US 2014314136 A1